# EUROPÄISCHE PATENTSCHRIFT

(11) **EP 2 152 627 B1**
(45) Veröffentlichungstag und Bekanntmachung des Hinweises auf die Patenterteilung: **10.10.2012**
(21) Anmeldenummer: 08717248.2
(22) Anmeldetag: 29.02.2008
(51) Int. Cl.: B81B 3/00, G01L 9/00

(54) **Mikromechanischer Membransensor und entsprechendes Herstellungsverfahren**
Micromechanical membrane sensor and corresponding production method
Capteur micro-mécanique a membrane et procédé de réalisation correspondant

(30) Priorität: 26.04.2007 DE 102007019639
(43) Veröffentlichungstag der Anmeldung: 17.02.2010
(73) Patentinhaber: Robert Bosch GmbH, 70442 Stuttgart (DE)
(72) Erfinder: KNESE, Kathrin, 70374 Stuttgart (DE); WEBER, Heribert, 72622 Nuertingen (DE); ARMBRUSTER, Simon, 72810 Gomaringen (DE)
(86) Internationale Anmeldenummer: PCT/EP2008/052467
(87) Internationale Veröffentlichungsnummer: WO 2008/131981

(56) Entgegenhaltungen:
- EP-A- 1 215 476
- EP-A- 1 671 923
- DE-A1-102004 036 032
- HE ET AL: "A silicon directly bonded capacitive absolute pressure sensor" SENSORS AND ACTUATORS A, ELSEVIER SEQUOIA S.A., LAUSANNE, CH, Bd. 135, Nr. 2, 4. April 2007 (2007-04-04), Seiten 507-514, XP022016213 ISSN: 0924-4247

## Beschreibung

### STAND DER TECHNIK

Die vorliegende Erfindung betrifft ein mikromechanisches Bauelement. Die vorliegende Erfindung betrifft ebenfalls ein entsprechendes Herstellungsverfahren.

Obwohl prinzipiell auf eine Vielzahl mikromechanischer Bauelemente anwendbar, werden die vorliegende Erfindung sowie die ihr zugrundeliegende Problematik anhand von kapazitiven Drucksensoren erläutert.

Ausgangspunkt zur Erläuterung der der vorliegenden Erfindung zugrundeliegenden Problematik ist ein kapazitiver Drucksensor, bei dem die Kapazität einer durch Druckbeaufschlagung elastisch auslenkbaren ersten Elektrode und einer dazu beabstandeten und davon elektrisch isolierten starren zweiten Elektrode als Elektrodenpaar ausgewertet wird.

Allgemein bekannt sind kapazitive Oberflächenmikromechanik-Drucksensoren, welche derart aufgebaut sind, dass Opferschichten unterhalb einer Membran durch Löcher in der Membran oder durch seitliche Zugänge unter der Membran entfernt werden, wobei die Membran die erste elastisch auslenkbare Elektrode bildet. Die Löcher müssen anschließend wieder verschlossen werden und wirken sich zudem nachteilig auf die Stabilität und Dichtheit der Membran aus. Weiterhin ist es bekannt, dass beim Einsatz einer Silizium-Membran diese aus polykristallinem Silizium besteht. Dies ist insofern zweckmäßig, als dass durch die elektrische Isolation der beiden Elektroden die Membranelektrode nur aus Polysilizium oder aus einer polykristallinen Epitaxie-Silizium-Schicht bestehen kann, die Polysilizium als Startschicht nutzt. Gegenüber monokristallinem Silizium besitzt polykristallines Silizium allerdings deutlich schlechtere elektrische und mechanische Eigenschaften.

Aus der DE 10 2004 036 032 A1 und der DE 10 2004 036 035 A1 bzw. der DE 100 32 579 A1 ist ein Verfahren zur Herstellung eines mikromechanischen Bauelements, insbesondere eines Membransensors, bekannt, wobei auf einem p-dotierten Halbleitersubstrat ein freitragendes monokristallines n-dotiertes Siliziumgitter vorgesehen wird, unter dem ein Hohlraum durch selektives Herauslösen oder durch Umlagerung von porösifiziertem Substratmaterial in Hochtemperaturschritten gebildet wird. Über dem monokristallinen n-dotierten Siliziumgitter befindet sich eine Membran aus monokristallinem Silizium, welche mit Hilfe eines Epitaxie-Verfahren gebildet wird.

Die EP 1 215 476 A beschreibt die Herstellung eines mikromechanischen Drucksensors mit einem n-leitenden Substrat und einer darüber angeordneten n-leitenden Schicht, die einen elastisch auslenkbaren Membranbereich aus monokristallinem Silizium über einem Hohlraum im Substrat bildet. Über dem auslenkbaren Membranbereich ist eine gelochte elektrisch isolierte Gegenelektrode angeordnet.

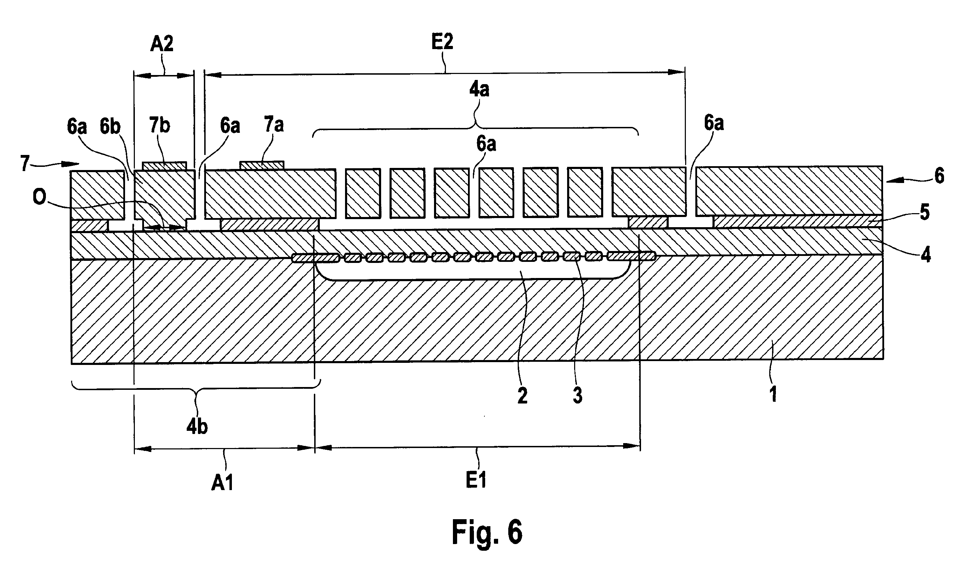

Fig. 6 zeigt eine schematische Querschnittsansicht eines kapazitiven Drucksensors zur Erläuterung des Aufbaus eines mikromechanischen Bauelements in Form eines kapazitiven Drucksensors zur Erläuterung der der vorliegenden Erfindung zugrundeliegenden Problematik.

In Figur 6 bezeichnet Bezugszeichen 1 ein p-dotiertes Silizium-Halbleitersubstrat, über dem gemäß der Lehre der DE 10 2004 036 032 A1 bzw. DE 10 2004 036 035 A1 ein freitragendes monokristallines n-dotiertes Siliziumgitter 3 mit darunter liegendem Hohlraum 2 gebildet worden ist. Über dem n-dotierten Siliziumgitter 3 liegt eine monokristalline epitaktisch abgeschiedene Siliziumschicht 4 mit einem Membranbereich 4a, welcher als erster elastisch auslenkbarer Elektrodenbereich E1 des mikromechanischen kapazitiven Drucksensors dient. Seitlich davon vorgesehen ist ein Peripherieberich 4b der monokristallinen epitaktisch abgeschiedenen Siliziumschicht 4, welcher als erster Anschlussbereich A1 des mikromechanischen kapazitiven Drucksensors dient.

Auf die monokristalline Siliziumschicht 4 wird eine isolierende Opferschicht 5, welche beispielsweise aus Siliziumoxid besteht, mit bekannten Methoden aufgebracht und strukturiert. Über eine oder mehrere in der Opferschicht 5 geschaffene Öffnungen O lassen sich die monokristalline Siliziumschicht 4, insbesondere deren Peripheriebereich 4b und somit auch das darunter liegende Siliziumsubstrat 1 elektrisch kontaktieren. Dies geschieht dadurch, dass nach Bildung einer oder mehrerer Öffnungen O eine polykristalline epitaktische Siliziumschicht 6 auf der Opferschicht 5 abgeschieden wird. Im Bereich der Öffnungen O kann die epitaktische Siliziumschicht 6 sowohl poly- als auch monokristallin, je nach verwendeter Startschicht, ausgeführt sein.

Mittels einer photolithographischen Technik, gefolgt von einem Trench-Ätzschritt zum Bilden von durchgehenden Gräben 6a, wird nun die polykristalline Siliziumschicht 6 derart strukturiert, dass eine elektrische Trennung des zweiten Elektrodenbereichs E2 und des zweiten Anschlussbereichs A2 erreicht werden kann. Ein oder mehrere freistehende Elemente 6b der polykristallinen epitaktischen Siliziumschicht 6, welche den zweiten Anschlussbereich A2 bilden, sind somit elektrisch mit dem ersten An-schlussbereich A1 der monokristallinen Siliziumschicht 4 verbunden und dienen zu deren Kontaktierung von aussen. Weiterhin werden die Gräben 6a dazu verwendet, im zweiten Elektrodenbereich E2 eine Perforation zu erzeugen, durch welche mittels Opferschichtätzen (z.B. Gasphasen-Ätzen) die Opferschicht 5 zwischen der ersten monokristallinen Siliziumschicht 4 und der zweiten polykristallinen Siliziumschicht 6 entfernt werden kann. Auf diese Art und Weise erhält man einen monokristallinen ersten Elektrodenbereich E1 dessen Auslenkung bezüglich des zweiten Elektrodenbereichs E2 kapazitiv ausgewertet werden kann.

Im Anschluss daran erfolgt das Abscheiden und Strukturieren einer Metallisierungsebene 7, auf der Kontaktierungsflächen 7a, 7b gebildet werden, über die der zweite Elektrodenbereich E2 bzw. der zweite Anschlussbereich A2 durch Drahtbonden mit entsprechenden Anschlüssen eines (nicht gezeigten) Gehäuses verbunden werden können. Nachteilig bei einem derartigen Aufbau sind allerdings die relativ hohen Streukapazitäten des Substrats 1 und der monokristallinen Siliziumschicht 4 bezüglich des (nicht gezeigten) Gehäuses.

### VORTEILE DER ERFINDUNG

Das erfindungsgemäße mikromechanische Bauelement mit den Merkmalen des Anspruchs 1 bzw. das Herstellungsverfahren nach Anspruch 12 weisen den Vorteil auf, dass sie einen einfachen und sicheren Prozess zur Herstellung von mikromechanischen Bauelementen, insbesondere kapazitiven Drucksensoren, vorschlagen, der sich kostengünstig umsetzen lässt. Die Erfindung ermöglicht insbesondere einen kapazitiven Drucksensor, welcher weniger durch Streukapazitäten beeinflusst ist. Weitere Vorteile liegen darin, dass das mechanisch aktive Element (Membran) aus monokristallinem Si (Bruch-/ Rissstabilität, bekannte Materialkennzahlen, ...) ist und den Hohlraum langfristig und zuverlässig abdichtet (im Unterschied zu Poly-Si, LPCVD-SiN, ...).

Die der vorliegenden Erfindung zugrundeliegende Idee besteht darin, zur Verringerung der Streukapazitäten nicht die Membranschicht und damit gleichzeitig das darunterliegende Substrat als Ganzes zu kontaktieren, sondern eine weitere Leiterbahnebene bzw. Verdrahtungsebene elektrisch isoliert auf der Membranebene zu erzeugen. Die elektrische Kontaktierung der zusätzlichen Verdrahtungsebene bzw. Leiterbahnebene erfolgt zweckmäßigerweise ebenfalls über einen beispielsweise durch Trenchen erzeugten isolierten Bereich in der Schicht, welche auch die obere zweite starre Elektrode bildet. Im Fall, dass die Ebene der zweiten starren Elektrode durch Epitaxie erzeugt wird, ist es von Vorteil, die zusätzliche Verdrahtungsebene bzw. Leiterbahnebene aus Polysilizium (optional auch dotiert) vorzusehen, da bei der Epitaxie relativ hohe Temperaturen entstehen.

In den Unteransprüchen finden sich vorteilhafte Weiterbildungen und Verbesserungen des jeweiligen Gegenstandes der Erfindung.

Gemäß einer bevorzugten Weiterbildung ist in der ersten leitfähigen Schicht (epitaktisch aufgewachsene monokristalline Siliziumschicht) eine Schaltungsanordnung integriert und der erste Anschlussbereich sowie der zweite Elektrodenbereich mit der Schaltungsanordnung elektrisch verbunden.

Gemäß einer weiteren bevorzugten Weiterbildung weist die zweite leitfähige Schicht (zweite epitaktisch aufgewachsene Siliziumschicht) sowohl polykristallin als auch monokristallin aufgewachsene Bereiche auf, wobei in den monokristallinen Bereichen eine Schaltungsanordnung integriert ist.

Gemäß einer weiteren bevorzugten Weiterbildung weist das Substrat auf seiner dem Membranbereich gegenüberliegenden Seite (Substratrückseite) Perforationsöffnungen auf, die den Hohlraum von hinten zugänglich machen. Auf diese Weise kann aus einem Absolutdrucksensor ein Relativdrucksensor realisiert werden.

Gemäß einer weiteren bevorzugten Weiterbildung weisen der zweite Elektrodenbereich und/oder der zweite Anschlussbereich Durchkontaktierungsbereiche auf, welche elektrisch isoliert durch das Substrat zur dem Membranbereich gegenüberliegenden Seite des Substrats geführt sind und mit elektrischen Kontaktflächen verbunden sind.

### ZEICHNUNGEN

Ausführungsbeispiele der Erfindung sind in den Zeichnungen dargestellt und werden in der nachfolgenden Beschreibung näher erläutert.

Es zeigen:
- Fig. 1: eine schematische Querschnittsansicht eines kapazitiven Drucksensors zur Erläuterung des Aufbaus eines mikromechanischen Bauelements in Form eines kapazitiven Drucksensors gemäß einer ersten Ausführungsfonn der vorliegenden Erfindung;
- Fig. 2: eine schematische Querschnittsansicht eines kapazitiven Drucksensors zur Erläuterung des Aufbaus eines mikromechanischen Bauelements in Form eines kapazitiven Drucksensors gemäß einer zweiten Ausführungsform der vorliegenden Erfindung;
- Fig. 3: eine schematische Querschnittsansicht eines kapazitiven Drucksensors zur Erläuterung des Aufbaus eines mikromechanischen Bauelements in Form eines kapazitiven Drucksensors gemäß einer dritten Ausführungsform der vorliegenden Erfindung;
- Fig. 4: eine schematische Querschnittsansicht eines kapazitiven Drucksensors zur Erläuterung des Aufbaus eines mikromechanischen Bauelements in Form eines kapazitiven Drucksensors gemäß einer vierten Ausführungsform der vorliegenden Erfindung;
- Fig. 5: eine schematische Querschnittsansicht eines kapazitiven Drucksensors zur Erläuterung des Aufbaus eines mikromechanischen Bauelements in Form eines kapazitiven Drucksensors gemäß einer fünften Ausführungsform der vorliegenden Erfindung; und
- Fig. 6: eine schematische Querschnittsansicht eines kapazitiven Drucksensors zur Erläuterung des Aufbaus eines mikromechanischen Bauelements in Form eines kapazitiven Drucksensors zur Erläuterung der der vorliegenden Erfindung zugrundeliegenden Problematik.

### BESCHREIBUNG DER AUSFÜHRUNGSBEISPIELE

In den Figuren bezeichnen gleiche Bezugszeichen gleiche oder funktionsgleiche Komponenten.

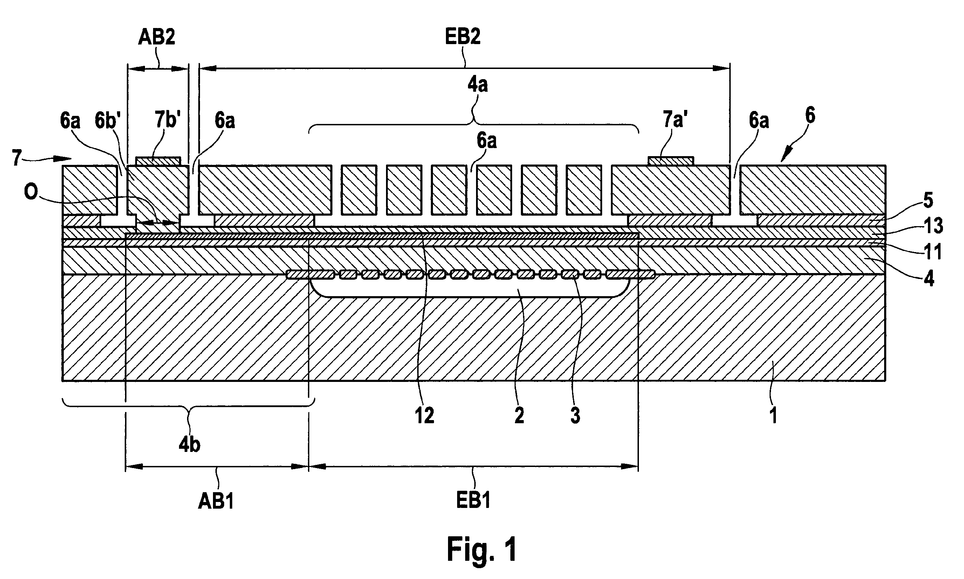

Fig. 1 zeigt eine schematische Querschnittsansicht eines kapazitiven Drucksensors zur Erläuterung des Aufbaus eines mikromechanischen Bauelements in Form eines kapazitiven Drucksensors gemäß einer ersten Ausführungsform der vorliegenden Erfindung.

In Figur 1 bezeichnet Bezugszeichen 1 ein leitfähiges Silizium-Substrat mit einer ersten leitfähigen Schicht 4 aus monokristallinem Silizium, welche über dem Substrat 1 vorgesehen ist und über einem im Substrat 1 vorgesehenen Hohlraum 2 einen elastisch auslenkbaren Membranbereich 4a und daran angrenzend einen Peripheriebereich 4b bildet. Herstellungsbedingt (siehe oben zu Fig. 6) ist über dem Hohlraum 2 zwischen dem Substrat 1 und der ersten leitfähigen Schicht 4 ein monokristallines Siliziumgitter 3 vorgesehen, welches auch im Membranbereich 4a eine monokristallin aufwachsende, leitfähige Schicht 4 ermöglicht.

Auf dieser ersten leitfähigen Schicht 4 aus monokristallinem Silizium ist eine erste Isolationsschicht 11 aus Siliziumoxid vorgesehen, auf der wiederum eine Leiterbahnebene 12 aus polykristallinem Silizium elektrisch isoliert von der ersten leitfähigen Schicht 4 vorgesehen ist, wobei die Leiterbalmebene 12 über dem Membranbereich 4a einen großflächigen ersten Elektrodenbereich EB1 und über dem Peripheriebereich 4b einen elektrisch damit verbundenen streifenartigen ersten Anschlussbereich AB1aufweist.

Auf der Leiterbahnebene 12 ist eine zweite Isolationsschicht 13 aus Siliziumnitrid vorgesehen, worüber sich eine Opferschicht 5 aus Siliziumoxid befindet. Die Schichten 13 und 5 können hierbei jeweils einzeln oder aber auch gemeinsam strukturiert werden. Über der Opferschicht 5 ist eine zweite leitfähigen Schicht 6 aus polykristallinem Silizium vorgesehen, die über dem Membranbereich 4a einen zweiten Elektrodenbereich EB2 aufweist, der vom ersten Elektrodenbereich EB1 elektrisch isoliert ist, und die über dem Peripheriebereich 4b einen zweiten Anschlussbereich AB2 aufweist, der vom zweiten Elektrodenbereich EB2 elektrisch isoliert ist und der mit dem ersten Anschlussbereich AB1 über eine entsprechende Öffnung O der zweiten Isolationsschicht 13 und der Opferschicht 5 elektrisch verbunden ist.

Zur Herstellung der in Fig. 1 dargestellten ersten Ausführungsform wird im Anschluss an die Abscheidung der monokristallinen Siliziumschicht 4 (bis dahin siehe oben zu Fig. 6) die erste Isolationsschicht 11 aus Siliziumoxid auf der monokristallinen Siliziumschicht 4 abgeschieden.

Danach wird die Leiterbahnebene 12 aus polykristallinem Silizium auf der ersten Isolationsschicht 11 abgeschieden und strukturiert. Insbesondere dient die Leiterbahnebene 12 im Membranbereich 4a als erster Elektrodenbereich EB1 und ist dort großflächig zu gestalten. Außerhalb des Membranbereichs 4a ist ein Zuleitungsbereich zu bilden, der einen schmaleren Durchmesser aufweisen kann. Nach dem Strukturieren der Leiterbahnebene 12 wird die zweite Isolationsschicht 13 aus Siliziumnitrid über der gesamten Struktur ganzflächig abgeschieden. Im Anschluss daran wird die Opferschicht 5 aus Siliziumoxid über der zweiten Isolationsschicht 13 aus Siliziumnitrid abgeschieden.

Danach wird eine Öffnung O in der zweiten Isolationsschicht 13 und der Opferschicht 5 für die elektrische Anbindung des ersten Anschlussbereichs AB1 der Leiterbahnebene 12 gebildet. Dann wird die polykristalline Siliziumschicht 6 epitaktisch auf der Opferschicht 5 bzw. in der Öffnung O aufgewachsen. Im Anschluss daran erfolgt das Abscheiden und Strukturieren einer Metallisierungsebene 7, mit der die Kontaktierungsflächen 7a', 7b' gebildet werden, über die der zweite Elektrodenbereich EB2 bzw. der zweite Anschlussbereich AB2 durch Drahtbonden mit entsprechenden Anschlüssen eines (nicht gezeigten) Gehäuses verbunden werden können.

Mittels einer photolithographischen Technik, gefolgt von einem Trench-Ätzschritt zum Bilden von durchgehenden Gräben 6a, wird nun die polykristalline Siliziumschicht 6 derart strukturiert, dass eine elektrische Trennung des zweiten Elektrodenbereichs EB2 und des zweiten Anschlussbereichs AB2 erreicht werden kann. Ein oder mehrere freistehende Elemente 6b' der polykristallinen epitaktischen Siliziumschicht 6, welche den zweiten Anschlussbereich AB2 bilden, sind somit durch die Öffnung O elektrisch mit dem ersten Anschlussbereich AB1 der polykristallinen Leiterbahnebene 12 verbunden und dienen zu deren Kontaktierung von außen. Weiterhin werden die Gräben 6a dazu verwendet, im zweiten Elektrodenbereich EB2 eine gitterartige Perforation zu erzeugen, durch welche mittels Gasphasen-Ätzen die Opferschicht 5 zwischen der Isolationsschicht 13 und der zweiten polykristallinen Siliziumschicht 6 entfernt werden kann. Auf diese Art und Weise erhält man einen ersten Elektrodenbereich EB1 mit monokristalliner Siliziummembran dessen Auslenkung bezüglich des zweiten Elektrodenbereichs EB2 kapazitiv ausgewertet werden kann.

Wie aus Figur 1 ersichtlich, ist durch den freistehenden Bereich 6b' der polykristallinen Polysiliziumschicht 6 im Anschlussbereich AB2 die Leiterbahnebene 12 kontaktiert, welche wiederum durch die erste und zweite Isolationsschicht 11, 13 nach unten bzw. oben und seitlich elektrisch isoliert ist. Daher kann bei dieser Ausführungsform eine direkte elektrische Kontaktierung der monokristallinen Siliziumschicht 4 und damit des Substrats 1 vermieden werden, was zur Beseitigung der Effekte der Streukapazitäten beiträgt.

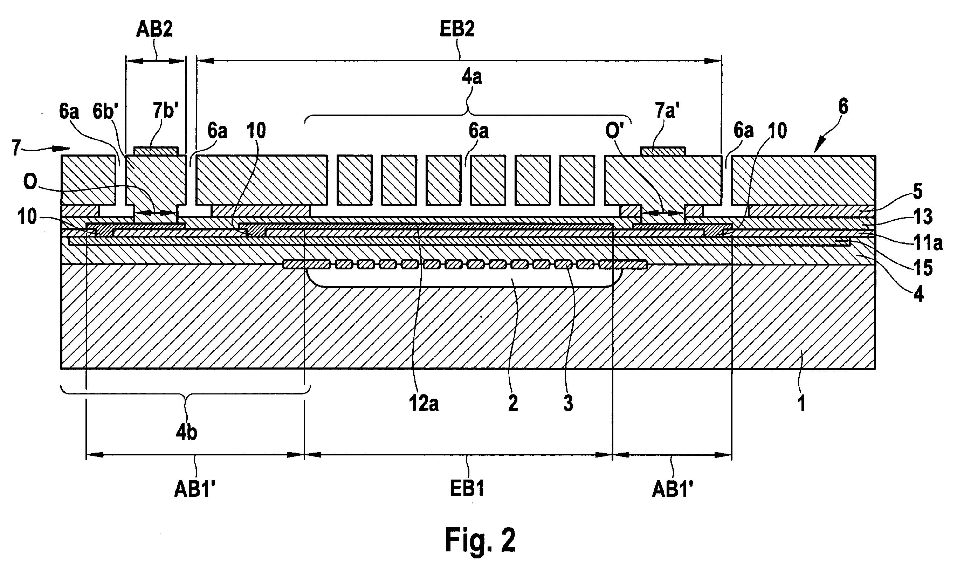

Fig. 2 zeigt eine schematische Querschnittsansicht eines kapazitiven Drucksensors zur Erläuterung des Aufbaus eines mikromechanischen Bauelements in Form eines kapazitiven Drucksensors gemäß einer zweiten Ausführungsform der vorliegenden Erfindung.

Bei der zweiten Ausführungsform ist in der ersten leitfähigen Schicht 4 eine Schaltungsanordnung 15 integriert und der erste Anschlussbereich AB1' mit der Schaltungsanordnung 15 über Durchkontaktierungen 10 elektrisch verbunden. Weiterhin ist auch der zweite Elektrodenbereich EB2 über eine Öffnung O' in der zweiten Isolationsschicht 13 und der Opferschicht 5 und über den ersten Anschlussbereich AB1' mit der Schaltungsanordnung 15 elektrisch verbunden. Diese zweite Ausführungsform hat den Vorteil, dass die gesamte Auswertung der Signale der beiden Elektrodenbereiche EB1, EB2 in der Schaltungsanordnung 15 stattfinden kann und im zweiten Anschlussbereich AB2 bereits das elektrisch aufbreitete Sensorsignal extern abgreifbar ist.

Zur Herstellung der in Fig. 2 dargestellten zweiten Ausführungsform wird nach Aufbringen der monokristallinen Siliziumschicht 4 in der monokristallinen Siliziumschicht 4 die integrierte elektrische Schaltungsanordnung 15 hergestellt. Insbesondere ist die integrierte elektrische Schaltungsanordnung 15 über Durchkontaktierungen 10 mit der über der ersten Isolationsschicht 11a liegenden Leiterbahnebene 12a verbunden, welche durch Bilden entsprechender Durchgangslöcher und Abscheiden und Strukturieren der Verdrahtungsschicht 12a gebildet werden. Im Anschluss daran wird nach Strukturierung der Leiterbahnebene 12a, welche auch im vorliegenden Beispiel aus Polysilizium besteht, die zweite Isolationsschicht 13 über der gesamten Struktur abgeschieden, wonach die folgenden Prozessschritte wie bei der oben erläuterten ersten Ausführungsform ablaufen. Einziger Unterschied bei der zweiten Ausführungsform ist, dass die polykristallinen Siliziumschicht 6 die Leiterbahnebene 12a durch die Öffnung O' kontaktiert und keine Kontaktfläche auf dem Elektrodenbereich EB2 vorgesehen ist, da durch die integrierte Schaltungsanordnung das Kapazitätssignal unmittelbar auf dem Sensorelement ausgewertet wird.

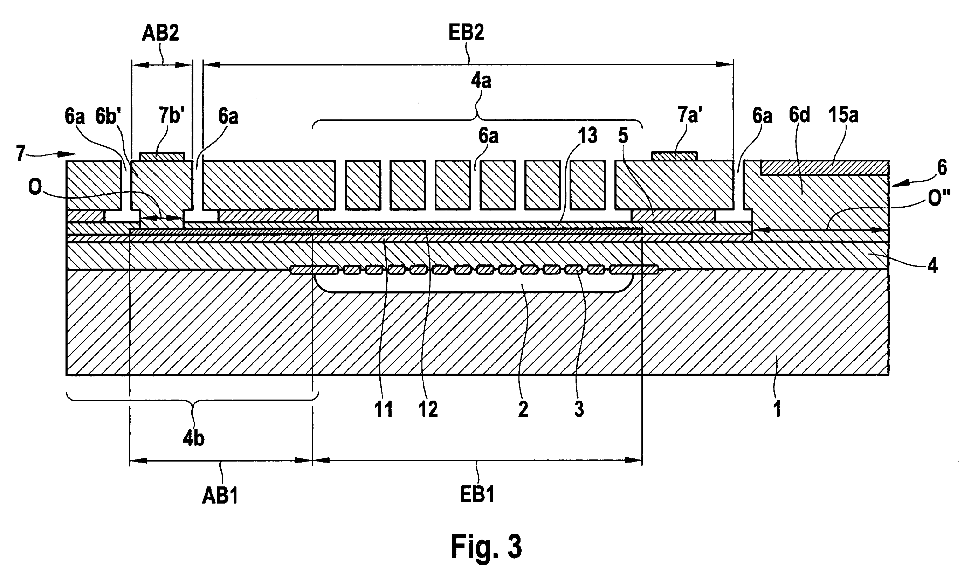

Fig. 3 zeigt eine schematische Querschnittsansicht eines kapazitiven Drucksensors zur Erläuterung des Aufbaus eines mikromechanischen Bauelements in Form eines kapazitiven Drucksensors gemäß einer dritten Ausführungsform der vorliegenden Erfindung.

Bei der dritten Ausführungsform ist der Aufbau entsprechend demjenigen gemäß der ersten Ausführungsform gemäß Figur 1 mit Ausnahme der Tatsache, dass eine integrierte elektrische Schaltungsanordnung 15a in der zweiten Siliziumschicht 6 vorgesehen ist. Hierbei ist Sorge zu tragen, dass in einem entsprechenden Bereich die zweite Siliziumschicht 6 epitaktisch monokristallin auf die monokristalline Siliziumschicht 4 bzw. das Substrat 1 monokristallin aufwachsen kann, um die integrierte Schaltung 15a realisieren zu können. Dies lässt sich durch Bilden einer entsprechenden Öffnung O" in der ersten Isolationsschicht 11, der zweiten Isolationsschicht 13 und der Opferschicht 5 (ggfs. auch in der monokristallinen Siliziumschicht 4) erreichten.

Sowohl bei der zweiten als auch bei der dritten Ausführungsform können die einzelnen Teile der integrierten Schaltungsanordnung 15 bzw. 15a auch mehrlagig ausgeführt werden. Bei der dritten Ausführungsform können die einzelnen Schaltungsteile der integrierten Schaltungsanordnung 15a auch durch zusätzliche Metallleiterbahnen verbunden werden, die ebenfalls wiederum mehrlagig ausgeführt werden können. Weiterhin könnten die Isolationsgräben 6a bei der dritten Ausführungsform in der Ebene der polykristallinen Siliziumschicht 6 mit einem Isolatormaterial verfüllt werden, was den Anschluss zu der integrierten Schaltung 15a stark vereinfacht.

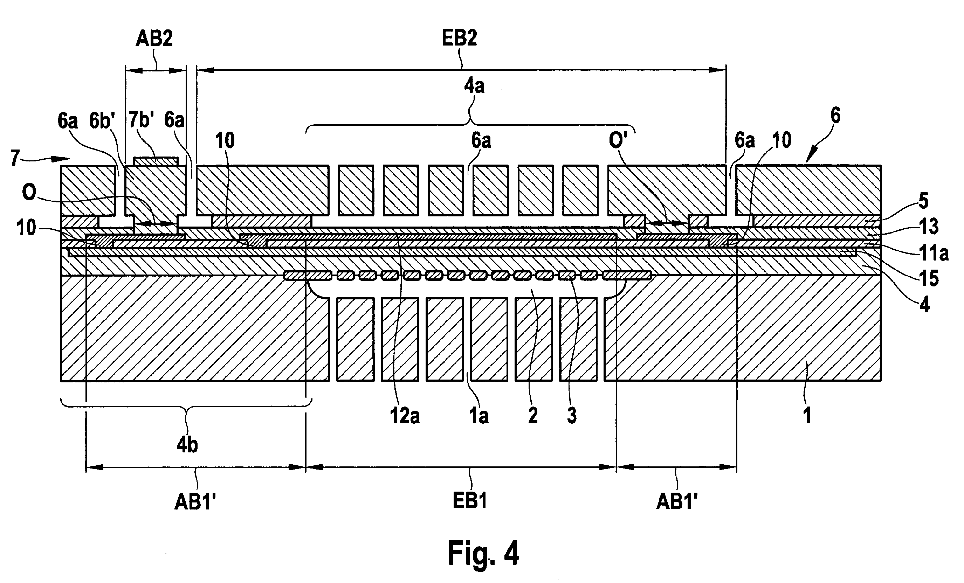

Fig. 4 zeigt eine schematische Querschnittsansicht eines kapazitiven Drucksensors zur Erläuterung des Aufbaus eines mikromechanischen Bauelements in Form eines kapazitiven Drucksensors gemäß einer vierten Ausführungsform der vorliegenden Erfindung.

Bei der vierten Ausführungsform sind als einziger Unterschied zu der in Figur 2 dargestellten zweiten Ausführungsform rückseitige Perforationslöcher 1a vorgesehen, welche den Hohlraum 2 von der Sensorrückseite zugänglich machen, wodurch die Herstellung eines Relativdrucksensors möglich ist. Zweckmäßigerweise erfolgt die Prozessierung der Rückseite des Substrats 1 zur Herstellung der Perforationslöcher 1a nach Fertigstellung der Prozessierung der Vorderseite des Substrats 1.

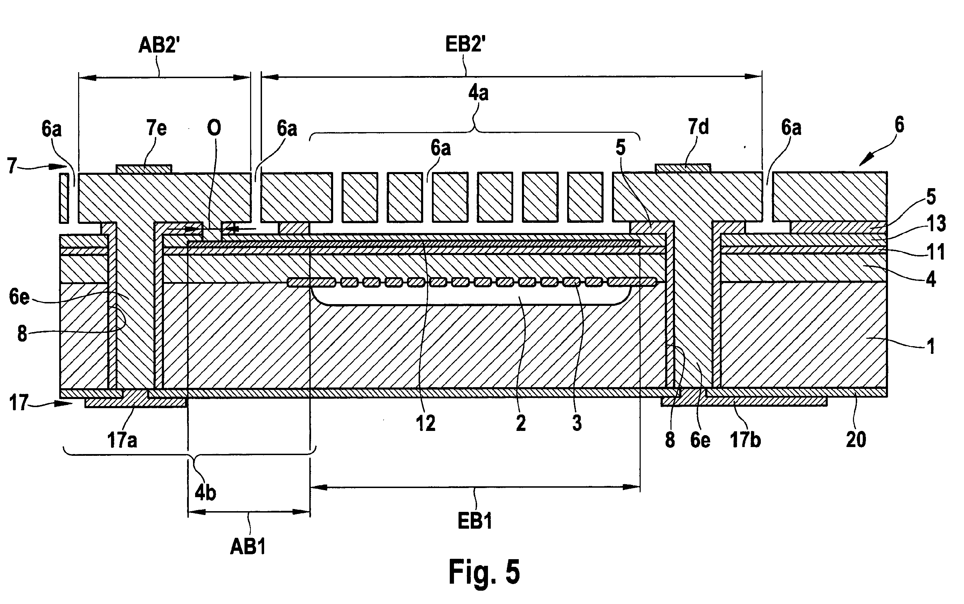

Fig. 5 zeigt eine schematische Querschnittsansicht eines kapazitiven Drucksensors zur Erläuterung des Aufbaus eines mikromechanischen Bauelements in Form eines kapazitiven Drucksensors gemäß einer fünften Ausführungsform der vorliegenden Erfindung.

Während die oben beschriebene erste bis vierte Ausführungsform die elektrische Kontaktierung des jeweiligen Drucksensors zur Außenwelt durch klassisches Drahtbonden an der Vorderseite vorsehen, ist mit der fünften Ausführungsform eine Variante möglich, bei der eine Wafer-Durchkontaktierung verwendet werden kann. Damit erhält man die Möglichkeit, Flip-Chip-Stapel aus Sensor- und Auswertechips aufzubauen. Diese Gestaltungsweise besitzt den Vorteil, Änderungen in Sensor- oder Auswertechips vornehmen zu können, ohne eine gegenseitige Beeinflussung in der Funktionalität in Kauf nehmen zu müssen.

Bei der fünften Ausführungsform werden nach Abscheidung der zweiten Isolationsschicht 13 von der Oberseite des Substrats 1 her Gräben 8 an den Stellen der gewünschten Durchkontaktierungen in das Substrat 1 geätzt. Danach erfolgt eine konforme Abscheidung der Opferschicht 5, welche auch die Seitenwände und den Boden der Gräben 8 bedeckt und damit für eine elektrische Isolation der Durchkontaktierungen gegenüber dem Substrat 1 und der monokristallinen Siliziumschicht 4 bildet.

Im Anschluss daran erfolgt, wie oben beschrieben, die Abscheidung und Strukturierung der polykristallinen Siliziumschicht 6, einer vorderseitigen Metallschicht 7 zum Bilden von Anschlussflächen 7d bzw. 7e für die Durchkontaktierungen 6e im zweiten Elektrodenbereich EB2' bzw. im zweiten Anschlussbereich AB2', sowie das Opferschichtätzen. Dabei werden die Gräben 8 mit der polykristallinen Siliziumschicht 6 gefüllt und bilden somit die späteren Durchkontaktierungsbereiche..

Im Anschluss daran, wird das Substrat 1 von der Rückseite her abgeschliffen, bis die Durchkontaktierungen 6e aus der polykristallinen Siliziumschicht 6 freigelegt sind, also die Opferschicht 5 von den Grabenböden entfernt ist. Danach erfolgt die Abscheidung und Strukturierung einer rückseitigen Isolationsschicht 20 und einer rückseitigen Metallschicht 17 zum Bilden von rückseitigen Anschlussflächen 17a bzw. 17b für die Durchkontaktierungen 6e im zweiten Anschlussbereich AB2' bzw. im zweiten Elektrodenbereich EB2'.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere können einzelne Prozessschritte auch untereinander in ihrer Reihenfolge vertauscht werden, ohne vom Gegenstand der Erfindung abzuweichen. So kann z.B. die Waferrückseitenprozessierung vor der Wafervorderseitenprozessierung erfolgen oder in sich abgeschlossen werden oder die Wafervorderseitenprozessierung kann zuerst erfolgen oder in sich abgeschlossen werden und danach die Waferrückseitenprozessierung stattfinden. Es können aber auch einzelne Verfahrensschritte auf der Wafervorderseite und auf der Waferrückseite einander im Gesamtprozessablauf sukzessive abwechseln, also einmal wird die Wafervorderseite prozessiert und dann wieder die Waferrückseite usw., und zwar jeweils über einen oder mehrere Schritte hinweg. Die oben erläuterten Prozessflüsse sind in vieler Hinsicht als vorteilhaft anzusehen, sind aber nicht die einzig möglichen Prozessabläufe im Sinne der vorliegenden Erfindung.

Die Isolation zu beiden Seiten der zusätzlichen Verdrahtungsebene bzw. Leiterbahnebene ist nicht auf zwei einzelne Isolationsschichten beschränkt, sondern kann vielmehr auch aus Kombinationen mehrerer verschiedener Isolatoren, wie z. B. Siliziumoxyd, Siliziumnitrid, Siliziumkarbid usw., bestehen.

Obwohl sich die zuvor beschriebenen Ausführungsbeispiele alle auf kapazitive Drucksensoren beziehen, sind sie nicht darauf beschränkt, sondern beispielsweise auch für kapazitive Mikrophone anwendbar. Auch lassen sich alle zuvor beschriebenen Ausführungsformen mit einer piezoresistiven Auswertevariante kombinieren. Man erhält so einen kapazitiven oder piezoresistiven Drucksensor mit Selbsttestmöglichkeit.

Zur Weiteren Reduzierung parasitärer Kapazitäten lassen sich alle zuvor vorgeschlagenen Ausführungsformen auch mit einer zusätzlichen elektrischen Isolation zwischen dem Substrat 1 und der monokristallinen Siliziumschicht 4 versehen.

Auch ist es möglich, alle mono- und polykristallin abgeschiedenen Siliziumschichten mit beliebiger Dotierung und beliebigen Dotierstoffkonzentrationen zu versehen.

## Patentansprüche

1. Mikromechanisches Bauelement mit:
einem leitfähigen Substrat (1);
einer ersten leitfähigen Schicht (4), welche über dem Substrat (1) vorgesehen ist und über einem im Substrat (1) vorgesehenen Hohlraum (2) einen elastisch auslenkbaren Membranbereich (4a) aus monokristallinem Silizium und daran angrenzend einen Peripheriebereich (4b) bildet;
einer Leiterbahnebene (12; 12a), welche auf einer ersten Isolationsschicht (11) vorgesehen ist, die auf der ersten leitfähigen Schicht (4) vorgesehen ist, wobei die Leiterbahnebene (12; 12a) über der ersten leitfähigen Schicht (4) elektrisch isoliert von der ersten leitfähigen Schicht (4) vorgesehen ist, wobei die Leiterbahnebene (12; 12a) über dem Membranbereich (4a) einen ersten Elektrodenbereich (EB1) und über dem Peripheriebereich (4b) einen elektrisch damit verbundenen ersten Anschlussbereich (AB1; AB1') aufweist; und
einer zweiten leitfähigen Schicht (6), welche über der Leiterbahnebene (12) vorgesehen ist, wobei die zweite leitfähige Schicht (6) über dem Membranbereich (4a) einen zweiten Elektrodenbereich (EB2; EB2') aufweist, der vom ersten Elektrodenbereich (EB1) elektrisch isoliert ist, und über dem Peripheriebereich (4b) einen zweiten Anschlussbereich (AB2; AB2') aufweist, der vom zweiten Elektrodenbereich (EB2; EB2') elektrisch isoliert ist und der mit dem ersten Anschlussbereich (AB1; AB1') elektrisch verbunden ist,
wobei vorgesehen ist, dass der zweite Elektrodenbereich(EB2; EB2') starr ausgebildet ist.

2. Mikromechanisches Bauelement nach Anspruch 1, **dadurch gekennzeichnet, dass** in der ersten leitfähigen Schicht (4) eine Schaltungsanordnung (15) integriert ist und der erste Anschlussbereich (AB1') mit der Schaltungsanordnung (15) elektrisch verbunden ist.

3. Mikromechanisches Bauelement nach Anspruch 2, **dadurch gekennzeichnet, dass** der zweite Elektrodenbereich (EB2; EB2') mit der Schaltungsanordnung (15) elektrisch verbunden ist.

4. Mikromechanisches Bauelement nach Anspruch 1, **dadurch gekennzeichnet, dass** die zweite leitfähige Schicht (6) einen Bereich (6d) aufweist, in den eine Schaltungsanordnung (15a) integriert ist.

5. Mikromechanisches Bauelement nach Anspruch 4, **dadurch gekennzeichnet, dass** die erste leitfähige Schicht (4) monokristallin ist und der Bereich (6d) monokristallin auf der ersten leitfähigen Schicht (4) aufgewachsen ist.

6. Mikromechanisches Bauelement nach Anspruch 4, **dadurch gekennzeichnet, dass** das Substrat (1) monokristallin ist und der Bereich (6d) monokristallin auf dem Substrat (1) aufgewachsen ist.

7. Mikromechanisches Bauelement nach Anspruch 1, **dadurch gekennzeichnet, dass** das Substrat (1) auf seiner dem Membranbereich (4a) gegenüberliegenden Seite Perforationsöffnungen (1a) aufweist, die den Hohlraum (2) von der Substratrückseite zugänglich machen.

8. Mikromechanisches Bauelement nach Anspruch 1, **dadurch gekennzeichnet, dass** der zweite Elektrodenbereich (EB2') und/oder der zweite Anschlussbereich (AB2') Durchkontaktierungsbereiche (6e) aufweisen, welche elektrisch isoliert durch das Substrat (1) zur dem Membranbereich (4a) gegenüberliegenden Seite des Substrats (1) geführt und mit elektrischen Kontaktflächen (17a, 17b) verbunden sind.

9. Mikromechanisches Bauelement nach Anspruch 1, **dadurch gekennzeichnet, dass** die erste leitfähige Schicht (4) aus monokristallinem Silizium und die zweite leitfähige Schicht (6) aus polykristallinem Silizium hergestellt ist.

10. Mikromechanisches Bauelement nach Anspruch 9, **dadurch gekennzeichnet, dass** über dem Hohlraum (2) zwischen dem Substrat (1) und der ersten leitfähigen Schicht (4) eine Gitterstruktur (3) aus monokristallinem Silizium vorgesehen ist.

11. Mikromechanisches Bauelement nach Anspruch 1, **dadurch gekennzeichnet, dass** die Leiterbahnebene (12; 12a) aus polykristallinem Silizium hergestellt ist.

12. Verfahren zum Herstellen eines mikromechanischen Bauelements mit den Schritten:
Bereitstellen eines leitfähigen Substrats (1) mit einem Hohlraum (2);
Bilden einer ersten leitfähigen Schicht (4) über dem Substrat (1), welche über dem Hohlraum (2) einen elastisch auslenkbaren Membranbereich (4a) aus monokristallinem Silizium und daran angrenzend einen Peripheriebereich (4b) bildet;
Bilden einer ersten Isolationsschicht (11; 11a) über der ersten leitfähigen Schicht (4);
Bilden einer Leiterbahnebene (12; 12a) über der ersten Isolationsschicht (11; 11a), wobei die Leiterbahnebene (12; 12a) über dem Membranbereich (4a) einen ersten Elektrodenbereich (EB1) und über dem Peripheriebereich (4b) einen elektrisch damit verbundenen ersten Anschlussbereich (AB1; AB1') aufweist;
Bilden einer zweiten Isolationsschicht (13) über der Leiterbahnebene (12; 12a);
Bilden einer Opferschichtebene (5) über der Isolationsschicht (13);
Bilden einer zweiten leitfähigen Schicht (6) über der Opferschichtebene (5), wobei die zweite leitfähige Schicht (6) über dem Membranbereich (4a) einen zweiten Elektrodenbereich (EB2; EB2') aufweist, der vom ersten Elektrodenbereich (EB1) elektrisch isoliert ist, und über dem Peripheriebereich (4b) einen zweiten Anschlussbereich (AB2; AB2') aufweist, der vom zweiten Elektrodenbereich (EB2; EB2') elektrisch isoliert ist und der mit dem ersten Anschlussbereich (AB1; AB1') elektrisch verbunden ist, Entfernen der Opferschicht (5) zwischen der Isolationsschicht (13) und der zweiten leitfähigen Schicht (6).

## Claims

1. Micromechanical component comprising:
a conductive substrate (1);
a first conductive layer (4), which is provided above the substrate (1) and forms above a cavity (2) provided in the substrate (1) an elastically deflectable membrane region (4a) composed of monocrystalline silicon and, adjacent thereto, a peripheral region (4b);
an interconnect plane (12; 12a) provided on a first insulation layer (11) provided on the first conductive layer (4), wherein the interconnect plane (12; 12a) is provided above the first conductive layer (4) in a manner electrically insulated from the first conductive layer (4), wherein the interconnect plane (12; 12a) has above the membrane region (4a) a first electrode region (EB1) and above the peripheral region (4b) a first connection region (AB1; AB1') electrically connected thereto; and
a second conductive layer (6), which is provided above the interconnect plane (12), wherein the second conductive layer (6) has above the membrane region (4a) a second electrode region (EB2; EB2'), which is electrically insulated from the first electrode region (EB1), and has above the peripheral region (4b) a second connection region (AB2; AB2') which is electrically insulated from the second electrode region (EB2; EB2') and which is electrically connected to the first connection region (AB1; AB1'),
wherein provision is made for the second electrode region (EB2; EB2') to be embodied in rigid fashion.

2. Micromechanical component according to Claim 1, **characterized in that** a circuit arrangement (15) is integrated in the first conductive layer (4) and the first connection region (AB1') is electrically connected to the circuit arrangement (15).

3. Micromechanical component according to Claim 2, **characterized in that** the second electrode region (EB2; EB2') is electrically connected to the circuit arrangement (15).

4. Micromechanical component according to Claim 1, **characterized in that** the second conductive layer (6) has a region (6d) into which a circuit arrangement (15a) is integrated.

5. Micromechanical component according to Claim 4, **characterized in that** the first conductive layer (4) is monocrystalline and the region (6d) is grown in monocrystalline fashion on the first conductive layer (4).

6. Micromechanical component according to Claim 4, **characterized in that** the substrate (1) is monocrystalline and the region (6d) is grown in monocrystalline fashion on the substrate (1).

7. Micromechanical component according to Claim 1, **characterized in that** the substrate (1) has perforation openings (1a) on its side opposite the membrane region (4a), said perforation openings making the cavity (2) accessible from the rear side of the substrate.

8. Micromechanical component according to Claim 1, **characterized in that** the second electrode region (EB2') and/or the second connection region (AB2') have/has plated-through hole regions (6e) which are led in an electrically insulated manner through the substrate (1) to the side of the substrate (1) opposite the membrane region (4a) and are connected to electrical contact areas (17a, 17b).

9. Micromechanical component according to Claim 1, **characterized in that** the first conductive layer (4) is produced from monocrystalline silicon and the second conductive layer (6) is produced from polycrystalline silicon.

10. Micromechanical component according to Claim 9, **characterized in that** a lattice structure (3) composed of monocrystalline silicon is provided above the cavity (2) between the substrate (1) and the first conductive layer (4).

11. Micromechanical component according to Claim 1, **characterized in that** the interconnect plane (12; 12a) is produced from polycrystalline silicon.

12. Method for producing a micromechanical component comprising the following steps:
providing a conductive substrate (1) having a cavity (2);
forming a first conductive layer (4) above the substrate (1), said layer forming above the cavity (2) an elastically deflectable membrane region (4a) composed of monocrystalline silicon and, adjacent thereto, a peripheral region (4b);
forming a first insulation layer (11; 11a) above the first conductive layer (4);
forming an interconnect plane (12; 12a) above the first insulation layer (11; 11a), wherein the interconnect plane (12; 12a) has above the membrane region (4a) a first electrode region (EB1) and above the peripheral region (4b) a first connection region (AB1; AB1') electrically connected thereto;
forming a second insulation layer (13) above the interconnect plane (12; 12a);
forming a sacrificial layer plane (5) above the insulation layer (13);
forming a second conductive layer (6) above the sacrificial layer plane (5), wherein the second conductive layer (6) has above the membrane region (4a) a second electrode region (EB2; EB2'), which is electrically insulated from the first electrode region (EB1), and has above the peripheral region (4b) a second connection region (AB2; AB2'), which is electrically insulated from the second electrode region (EB2; EB2') and which is electrically connected to the first connection region (AB1; AB1'),
removing the sacrificial layer (5) between the insulation layer (13) and the second conductive layer (6).

## Revendications

1. Composant micromécanique présentant :
un substrat conducteur (1),
une première couche conductrice (4) prévue au-dessus du substrat (1) et qui forme au-dessus d'une cavité (2) prévue dans le substrat (1) une partie (4a) en membrane élastiquement déformable de silicium monocristallin à laquelle est adjacente une partie périphérique (4b),
un plan (12; 12a) de pistes conductrices prévu sur une première couche isolante (11) prévue elle-même sur la première couche conductrice (4), le plan (12; 12a) de pistes conductrices étant prévu au-dessus de la première couche conductrice (4) en étant isolé électriquement de la première couche conductrice (4), le plan (12; 12a) de pistes conductrices présentant au-dessus de la partie (4a) en membrane une première partie d'électrode (EB1) et au-dessus de la partie périphérique (4b) une première partie de raccordement (AB1; AB1') reliée électriquement à cette dernière et
une deuxième couche conductrice (6) prévue au-dessus du plan (12) de pistes conductrices, la deuxième couche conductrice (6) présentant au-dessus de la partie en membrane (4a) une deuxième partie d'électrode (EB2; EB2') électriquement isolée de la première partie d'électrode (EB1) et au-dessus de la partie périphérique (4b) une deuxième partie de raccordement (AB2; AB2'), électriquement isolée de la deuxième partie d'électrode (EB2; EB2') et reliée électriquement à la première partie de raccordement (AB1; AB1'),
la deuxième partie d'électrode (EB2; EB2') étant rigide.

2. Composant micromécanique selon la revendication 1, **caractérisé en ce qu'**un circuit (15) est intégré dans la première couche conductrice (4) et **en ce que** la première partie de raccordement (AB1') est raccordée électriquement au circuit (15).

3. Composant micromécanique selon la revendication 2, **caractérisé en ce que** la deuxième partie d'électrode (EB2; EB2') est raccordée électriquement au circuit (15).

4. Composant micromécanique selon la revendication 1, **caractérisé en ce que** la deuxième couche conductrice (6) présente une partie (6d) dans laquelle est intégré un circuit (15a).

5. Composant micromécanique selon la revendication 4, **caractérisé en ce que** la première couche conductrice (4) est monocristalline et **en ce que** la partie (6d) est obtenue par croissance monocristalline sur la première couche conductrice (4).

6. Composant micromécanique selon la revendication 4, **caractérisé en ce que** le substrat (1) est monocristallin et **en ce que** la partie (6d) est obtenue par croissance monocristalline sur le substrat (1).

7. Composant micromécanique selon la revendication 1, **caractérisé en ce que** sur son côté opposé à la partie (4a) en membrane, le substrat (1) présente des perforations (1a) qui donnent accès à la cavité (2) depuis le côté arrière du substrat.

8. Composant micromécanique selon la revendication 1, **caractérisé en ce que** la deuxième partie d'électrode (EB2') et/ou la deuxième partie de raccordement (AB2') présentent des parties (6e) de mise en contact qui sont amenées à travers le substrat (1) de manière électriquement isolée vers le côté du substrat (1) opposé à la partie (4) en membrane et sont reliées à des surfaces (17a, 17b) de contact électrique.

9. Composant micromécanique selon la revendication 1, **caractérisé en ce que** la première couche conductrice (4) est réalisée en silicium monocristallin et la deuxième couche conductrice (6) en silicium polycristallin.

10. Composant micromécanique selon la revendication 9, **caractérisé en ce qu'**une structure en grille (3) de silicium monocristallin est prévue au-dessus de la cavité (2) entre le substrat (1) et la première couche conductrice (4).

11. Composant micromécanique selon la revendication 1, **caractérisé en ce que** le plan (12; 12a) de pistes conductrices est réalisé en silicium polycristallin.

12. Procédé de fabrication d'un composant micromécanique, le procédé comportant les étapes qui consistent à :
préparer un substrat conducteur (1) doté d'une cavité (2),
former au-dessus du substrat (1) une première couche conductrice (4) qui forme au-dessus de la cavité (2) une partie (4a) en membrane élastiquement déformable de silicium monocristallin et à laquelle est adjacente une partie périphérique (4b),
former une première couche isolante (11; 11a) au-dessus de la première couche conductrice (4),
former un plan (12; 12a) de pistes conductrices au-dessus de la première couche isolante (11; 11a), le plan (12; 12a) de pistes conductrices présentant au-dessus de la partie (4) en membrane une première partie d'électrode (EB1) et au-dessus de la partie périphérique (4b) une première partie de raccordement (AB1; AB1') reliée électriquement à cette dernière,
former une deuxième couche isolante (13) au-dessus du plan (12; 12a) de pistes conductrices,
former un plan (5) de couche sacrifiée au-dessus de la couche isolante (13),
former une deuxième couche conductrice (6) au-dessus du plan (5) de couche sacrifiée, la deuxième couche conductrice (6) présentant au-dessus de la partie (4) en membrane une deuxième partie d'électrode (EB2; EB2') électriquement isolée de la première partie d'électrode (EB1) et au-dessus de la partie périphérique (4b) une deuxième partie de raccordement (AB2; AB2') électriquement isolée de la deuxième partie d'électrode (EB2; EB2') et reliée électriquement à la première partie de raccordement (AB1; AB1') et
enlever la couche sacrifiée (5) entre la couche isolante (13) et la deuxième couche conductrice (6).
